Europäisches Patentamt

European Patent Office

Office européen des brevets

(11) Publication number: **0 251 187**
**A2**

# (12) EUROPEAN PATENT APPLICATION

(21) Application number: **87109092.4**

(22) Date of filing: **24.06.87**

(51) Int. Cl.4: **C08G 8/12 , H01L 21/31**

(30) Priority: **27.06.86 JP 149413/86**
**18.11.86 JP 272863/86**

(43) Date of publication of application:
**07.01.88 Bulletin 88/01**

(84) Designated Contracting States:
**DE FR GB**

(71) Applicant: **NIPPON ZEON CO., LTD.**
**6-1, 2-chome**
**Marunouchi Chiyoda-ku, Tokyo(JP)**

Applicant: **FUJITSU LIMITED**
**1015, Kamikodanaka Nakahara-ku**
**Kawasaki-shi Kanagawa 211(JP)**

(72) Inventor: **Sugimoto, Sadao c/o**
**Gijutsukaihatsu Center of**
**Nippon Zeon Co., Ltd. 2-1, Yako 1-chome**
**Kawasaki-ku Kawasaki-shi**
**Kanagawa-ken(JP)**
Inventor: **Kusunoki, Teturiyo c/o**
**Gijutsukaihatsu Center of**
**Nippon Zeon Co., Ltd. 2-1, Yako 1-chome**
**Kawasaki-ku Kawasaki-shi**
**Kanagawa-ken(JP)**
Inventor: **Yajima, Mikio c/o Gijutsukaihatsu**
**Center of**
**Nippon Zeon Co., Ltd. 2-1, Yako 1-chome**
**Kawasaki-ku Kawasaki-shi**
**Kanagawa-ken(JP)**
Inventor: **Takahashi, Nobukazu c/o**
**Gijutsukaihatsu Center of**
**Nippon Zeon Co., Ltd. 2-1, Yako 1-chome**
**Kawasaki-ku Kawasaki-shi**
**Kanagawa-ken(JP)**
Inventor: **Fujino, Katsuhiro**
**83-3, Nishihassaku-machi Midori-ku**
**Yokohama-shi Kanagawa-ken(JP)**
Inventor: **Yano, Hiroshi**
**29-6, Kashiwa-cho Asahi-ku**
**Yokohama-shi Kanagawa-ken(JP)**
Inventor: **Fujimura, Shuzo**
**Towa-City-Koupu-Koiwa No. 401 1-4-6,**
**Kitakoiwa**
**Edogawa-ku Tokyo(JP)**

(74) Representative: **Kraus, Walter, Dr. et al**
**Patentanwälte Kraus, Weisert & Partner**
**Thomas-Wimmer-Ring 15**
**D-8000 München 22(DE)**

(54) **Method for purifying novolak resins useful as material for coating on a semiconductor substrate.**

(57) A method of purifying novolak resins useful as a material for coating on a semiconductor substrate, which comprises dissolving a novolak resin in a solvent having a solubility in water at 20°C of not more than l00, and extracting the resulting solution with an acidic aqueous solution thereby to reduce the metal content of the resin. If desired, the solution may be subjected to both the extraction step and a centrifugal separation step in a desired sequence instead of the extraction step alone.

This invention relates to a method of purifying a novolak resin. More specifically, it relates to a method of reducing the metal content of a novolak resin useful as a material for coating on a semiconductor substrate, for example as a resist or a flattening material.

With an increase in the degree of integration and the speed of semiconductor elements in recent years, there has been a stronger need for finer elements. To meet this requirement, the conventional cyclized polyisoprene-bisazide type negative resist used for lithography is being superseded by a novolak resin-quinone diazide type positive resist. The cyclized polyisoprene-bisazide type resist utilizes the difference in solubility between a cyclized polyisoprene portion crosslinked with nitrene formed by photolysis of bisazide and a cyclized polyisoprene not crosslinked with it. When the non-crosslinked portion is to be removed (developed) with an organic solvent which is a good solvent for the cyclized polyisoprene, swelling of the crosslinked portion with the solvent cannot be avoided, and there is a limit in the increase of resolution. In contrast, the novolak resinquinone diazide type resist utilizes the fact that the novolak resin or a compound mixed with it has a quinone diazide structural portion, and this structural portion changes by light, namely its solubility in an aqueous alkaline developer after exposure greatly varies from that before exposure. Since the developer is water, this resist is essentially free from the problem of swelling, and can easily give a high resolution, sharpness of lines and high dimensional accuracy. Recently, a (negative) resist composed of a novolak resin and a bisazide compound utilizing this non-swellability was reported.

One required property of the resist which has recently assumed increasing importance is a low metal content. When a resin having a high metal content is used, the metal remains in a drawn pattern and deteriorates the electrical properties of a semiconductor. The resist is coated on a substrate (for example, a silicon substrate) by, for example, a spinner to a suitable thickness. The remaining solvent is removed by pre-baking, and the substrate is exposed through a mask having a desired pattern drawn there. The formed latent image is treated with a developer to form a visible image. By etching the substrate using this visible image as a mask, the desired pattern is transferred to the substrate. Etching of the substrate was previously performed mainly by wet etching using a aqueous hydrofluoric acid and the like. Gradually, it has been replaced by a dry etching technique utilizing an active species generated in a plasma discharge. Usually, the dry etching is employed in a resist comprising a novolak resin in view of its adhesion to the substrate. After the etching of the substrate, the unwanted resist is peeled. This step is now frequently performed by utilizing a plasma. When a solvent is used as in wet etching, the metals in the resist are partly removed by the solvent. In dry etching or peeling of the resist by a plasma, the metals in the resist mostly remain on the substrate and become a source of contamination of the substrate.

Thus, in addition to drawability of a fine pattern, the low metal content is another important property of the resist.

The metal contents of novolak resin-quinone diazide type resists now commercially available, however, are not as low as are satisfatory to the semiconductor manufacturers, and this remains a great problem in the production of semiconductors.

The main constituent elements of a typical novolak resin-quinone diazide type resist are a matrix resin such as a novolak resin, a dissolution inhibitor such as a quinone diazide compound, and a solvent.

The quinone diazide compound is generally obtained by reacting a compound having a quinone diazide structure such as naphthoquinone azide-5-sulfonyl chloride with a compound having a hydroxyl group such as 2,3,4-trihydroxybenzophenone or 2,3,4,4'-tetrahydroxybenzophenone in the presence of a weak alkali. It is easy to purify the starting material or the product by known methods, and a quinone diazide compound having a low metal content can be obtained. It is also easy to reduce the metal content of the solvent by distillation, for example.

The novolak resin is produced by dehydrocondensation phenol or a phenol derivative such as cresol and xylenol and an aldehyde such as formaldehyde or a ketone such as acetone at high temperatures in the presence of a catalsyt (for example, an inorganic acid such as hydrochloric acid and sulfuric acid, an organic acid such as oxalic acid, or a metal compound such as magnesium carbonate, zinc acetate or calcium hydroxide). Sometimes, the novolak resins is modified by addition of another compound (e.g., a silicon-containing compound). Such novolak resins contain magnesium, zinc, calcium, etc. derived from the above catalysts and iron, sodium, etc. derived from various raw materials and the production equipment.

Accordingly, most of the metals in the novolak resin-quinone diazide-type resist can be said to be derived from the novolak resin. The same can be said with regard to the metal contents of other resists comprising the novolak resin.

Recently, a so-called multilayer resist technique came into use in applying lithography to a substrate having a non-level surface in order to reduce effects of the non-level surface upon the pattern width. This technique comprises coating a flattening material on the substrate, then coating a resist on it, and subjecting it to lithography including exposure, development, dry etching, etc.

Sometimes, a resist is used as the flattening material, but it does not always have to be photosensitive. Frequently, a novolak resin alone is used as the flattening material. The metal content of the novolak resin used as the flattening material is a problem as is the case with the resist mentioned above.

The present inventors have extensively worked in order to remove the above defect, and have found that the metal content of the novolak resin can be reduced by purifying it by a particular method, and the use of the purified novolak resin can drastically reduce the metal content of a material for coating on a semiconductor substrate, typically a resist and a flattening material.

Thus, according to this invention, there is provided a method of purifying a novolak resin useful as a material for coating on a semiconductor substrate, which comprises dissolving the novolak resin in a solvent having a solubility in water (grams per l00 g of water) at 20°C of not more than l00, and extracting the resulting solution with an acidic aqueous solution having a pH of not more than 3.

The solvent used in this invention is a solvent for novolak resins and has a solubility in water at 20°C of not more than l00, preferably not more than 50. Specific examples include acetates such as ethyl acetate, n-butyl acetate and isoamyl acetate; ketones such as methyl ethyl ketone, methyl isobutyl ketone and cyclohexanone; alcohols such as n-butanol, i-butanol and i-amyl alcohol; glycol ether acetates such as ethylene glycol monoethyl ether acetate and ethylene glycol monobutyl ether acetate; halogenated hydrocarbons such as carbon tetrachloride, chloroform and tetrachloroethane; and ether, ligroin and solvent naptha. These solvents may be used singly or in combination. If the solubility of the solvent in water exceeds l00, the novolak resin may precipitate during purification or the separation of the novolak resin solution layer from the aqueous layer is difficult or impossible.

The amount (concentration) of the novolak resin to be dissolved in the solvent is not particularly limited. If the concentration of the novolak resin is low, the total amount of the solution becomes high and operational difficulty may arise. If the concentration is too high, the viscosity of the solution becomes high, and the separation of the solution from the aqueous layer becomes poor. The preferred concentration is 3% to 50%.

In liquid-liquid extraction, it is usual to add the acidic aqueous solution to the solution of the novolak resin. If desired, the novolak resin solution may be put in the acidic aqueous solution. Desirably, the acidic aqueous solution used contains little metals to meet the object of the present invention. Hence, water used is preferably pure water, particularly highly pure water. The amount of the acidic aqueous solution used is not an essential problem. Its suitable amount is l/l0 to l0 times the volume of the novolak resin solution. If it is less than l/l0 times, the number of extractions for metal removal increases. If it excees l0 times, part of the novolak resin will precipitate or the amount of the solution to be handled will increase. Water to be used for extraction should be adjusted to a pH of not more than 3 with sulfuric acid hydrochloric acid or acetic acid. The reason for this is not clear. It is presumed however that part to the metals contained in the novolak resin has a chelate structure and is more soluble in organic solvents than water, but that the acid changes this structure to cause it to acquire affinity for water.

The acidic aqueous solution and the novolak resin solution are well mixed by stirring or shaking, and then allowed to stand. Consequently, the mixture separates into a novolak resin solution layer and an aqueous layer. The novolak resin solution layer is separated by decantation, etc. Thereafter, with regard to the separated novolak resin solution layer, the above operations including addition of the acidic aqueous solution, mixing by stirring or shaking, standing and separation are repeated one to several times. If the acid remains in the novolak resin, it is likely to corrode the semiconductor substrate. It is preferred therefore to provide a step of water washing in the above operations, for example after the separating operation.

In the present invention, the efficiency of purification can be further increased by combining the above operations with a centrifugal separating operation. Centrifugation may be carried out after the addition of the acidic aqueous solution, mixing, standing, separation and water washing are repeated several times. Alternatively, a cycle of addition of the acidic aqueous solution, mixing, standing, separation, water washing and centrifugal separation may be repeated several times. Furthermore, the novolak resin solution may be subjected to the centrifugal separating operation before the first charge of the acidic aqueous solution is added to it. The advantage of centrifugal separation is twofold. Firstly, metal oxides remaining non-dissolved in the solvent are removed by this centrifugation. Secondly, metals in the form of salts contained in suspending water (derived from water used in the extraction) in the solvent are removed since the suspending water is removed from the solvent by centrifugal separation.

In addition to the liquid-liquid exraction and centrifugation, an operation of filtration on a filter is also effective for removing metals existing in insoluble form in the solvent.

The novolak resin is recovered from the novolak resin solution by a suitable method, for example, removal of the solvent from the solution by evaporation to dryness or a method comprising putting the solution in a non-solvent for the novolak resin to re-precipitate the nonvolak resins, and then collecting it by filtration.

The metal content of the resulting novolak resin is reduced drastically as compared with that before purification (usually to less than 50 ppb, and at times, to less than the detection limit). By mixing and dissolving the novolak resin and a quinone diazide compound in a solvent, a positive photoresist solution having a low metal content can be prepared.

Esters formed between compounds or polymers having a hydroxyl group such as hydroxybenzophenone, derivatives thereof, gallic acid, derivatives thereof or acetone-pyrogallol resins and o-naphthoquinonediazide-5-sulfonyl chloride are known to be useful as the quinone diazide compound, although it is not limited to these specific compounds. The amount of the quinone diazide compound used is usually from 1:1 to 1:6 with respect to the novolak resin.

Examples of the solvent are alcohols such as propanol and butanol; ketones such as methyl ethyl ketone, methyl isobutyl ketone and cyclohexanone; acetates such as ethyl acetate, butyl acetate and isoamyl acetate; cyclic ethers such as tetrahydrofuran and dioxane; methyl Cellosolve, ethyl Cellosolve, butyl Cellosolve, ethyl Cellosolve acetate, butyl Cellosolve acetate; and gammabutyrolactone. These solvents may be used in combination with aromatic hydrocarbons such as toluene and xylene.

The above positive photoresist composition may contain small amounts of additional resins, plasticizers, dyes, etc.

A negative resist having a low metal content may be obtained by using a purified novolak resin in accordance with the present invention in accordance with a method disclosed, for example, in Japanese Laid-Open Patent Publication No. 86831/1982.

Novolak resins purified by this invention may also be used as a flattening material.

Since according to this invention, a novolak resin having a reduced metal content as compared with the prior art can be obtained, the use of this novolak resin as a material for coating on a semiconductor substrate, for example as a resist composition or a flattening material can lead to the production of a semiconductor integrated circuit without deteriorating electrical properties. Hence, the present invention is specially useful where a fine pattern is required or the production of the semiconductor integrated circuit goes through a step of dry etching.

The following Examples, Comparative Examples and Referential Example illustrate the present invention more specifically. All percentages in these examples are by weight unless otherwise specified.

REFERENTIAL EXAMPLE

A novolak resin (SR-3020 NZ made by Suzuki Chemical Industry Co., Ltd.) was dissolved in metal-free methyl isobutyl ketone, and the total metal content of the novolak resin in the solution was measured by frameless atomic absorptiometry. It was found to contain 1,770 ppb of Fe, 280 ppb of Na, 63 ppb of Mn, 54 ppb of Cu, 12 ppb of Mg, 55 ppb of K, 20 ppb of Ca, 110 ppb of Zn, 320 ppb of Pb, 164 ppb of Ni, and 240 ppb of Cu, and its Al and Sn contents are below the detection limits (100 ppb for each).

EXAMPLE I

Ten grams of the novolak resin in Referential Example was dissolved in 90 g of methyl isobutyl ketone, and the solution was transferred to a 1-liter separation funnel. Five hundred grams of a 3% aqueous solution of sulfuric acid (pH 1) prepared from substantially metal-free ultrapure water and sulfuric acid was added to the solution. The mixture was well shaken, and left to stand for 30 minutes. The mixture was well shaken, and left to stand for 30 minutes. It separated into an upper novolak resin solution layer and a lower aqueous layer. The aqueous layer was removed. A fresh charge of the above 3% aqueous sulfuric acid solution was added to the remaining novolak resin solution layer. The mixture was again shaken and left to stand, and the separated aqueous layer was removed. This extracting operation was carried out five times in total. The contents of Na, K, Mn, Mg, Fe, Ca, Cu, Al, Sn, Zn, Pb, Ni and Cr in the resulting novolak resin were measured, and found to be below the detection limits. The defection limits were 2 ppb for Fe, 10 ppb for Al, Sn and Cr, 5 ppb for Pb and Ni, and 1 ppb for Na, Mn, Cu, Mg, K, Ca and Zn. The novolak resin solution was put in cyclohexane to give a novolak resin subtantially free from metals.

## EXAMPLE 2

Example I was repeated except that 8 g of the novolak resin was dissolved in 92 g of cyclohexanone. The metal contents of the resulting novolak resin were below the detection limits.

## EXAMPLE 3

Example I was repeated except that a 3% aqueous soution of acetic acid (pH 3) was used instead of the 3% aqueous sulfuric acid solution. The content of Fe in the novolak resin determined from the Fe content of the resulting solution was below the detection limit.

## COMPARATIVE EXAMPLE I

Example I was repeated except that acetone (having an solubility in water at 20°C of infinity) was used instead of methyl isobutyl ketone. After the first shaking, the mixture was left to stand for 480 minutes. However, it remained emulsified.

## EXAMPLES 4-8

Example I was repeated except that the type of the solvent, the concentration of the novolak resin solution and the volume ratio of the solution to water were varied as shown in Table I. The results are shown in Table I.

- 11 -

Table 1

| | Example | | | | |
|---|---|---|---|---|---|
| | 4 | 5 | 6 | 7 | 8 |
| Solvent | n-butanol | carbon tetra-chloride | ethylene glycol monobutyl ether acetate | methyl isobutyl ketone | isoamyl acetate |
| Concent-ration of the novolak resin solution (A) (%) | 8 | 6 | 5 | 15 | 12 |
| Aqueous sol-ution (B) used for extraction Acid | sulfuric acid | HCl | HCl | sulfuric acid | sulfuric acid |
| Concentr-ation (%) | 1 | 3 | 1 | 3 | 3 |
| pH | 1 | 1 | 1 | 1 | 1 |
| A/B volume ratio | 1/1 | 1/2 | 5/1 | 2/1 | 1/1 |
| Number of extractions | 5 | 5 | 5 | 5 | 5 |
| Metal content | Below the detection limits for the 13 metals described in Example 1 | | | | |

COMPARATIVE EXAMPLE 2

A commercial novolak resin-quinone diazide type photoresist (containing 120 ppb of Fe, 308 ppb of Pb, 68 ppb of Mn, 14 ppb of K and 6 ppb of Na) was coated on a silicon substrate to a thickness of 1 micron, and then peeled by a plasma [300 cc oxygen, 300 W (13.56 MHz), 1 torr]. Then, a diode was constructed and the generation life time ($\tau$ g) was measured (the measurement of the capacity-time, or C-T) and found to be 30 to 100 microseconds. When a diode was constructed on a non-treated silicon substrate, the generation life time was 300 to 500 microseconds.

EXAMPLE 9

Ten grams of the novolak resin obtained in Example 1 and 3 g of a compound obtained by reacting o-naphthoquinone diazide-5-sulfonyl chloride and 2,3,4-trihydroxybenzophenone in a mole ratio of 2:1 were dissolved in 33 g of ethylene glycol monoethyl ether acetate. The solution was then filtered through a filter having a pore diameter of 0.2 micrometer to form a positive photoresist composition.

The resist composition was coated and peeled under the same conditions as in Comparative Example 2. The C-T was 200 to 400 microseconds. This is close to the C-T obtained with non-treated silicon substrate, and shows that the characteristics of the element greatly improved over the case of conventional general resists.

EXAMPLE 10

Ten grams of the novolak resin of Referential Example was dissolved in 90 g of methyl isobutyl ketone, and the solution was transferred to a 1-liter separation funnel. To the solution was added 500 g of a 3% aqueous solution of sulfuric acid (pH 1). The mixture was well shaken, and left to stand for 30 minutes. It separated into an upper novolak resin solution layer and a lower aqueous layer. The aqueous layer was removed. The remaining novolak resin solution layer was separated at 5,000 rpm and 10°C for 15 minutes by a centrifugal separator (Model H251 made by Kokusan Enshinki K. K.). The novolak resin solution layer was taken out, and transferred to a 1 liter separation funnel. A fresh charge of the 3% aqueous sulfuric acid solution was added, and the mixture was again shaken and left to stand. The separated aqueous layer was removed, and the remaining solution was centrifuged. This series of operations were repeated three times in total. The contents of Na, K, Mn, Mg, Fe, Ca, Cu, Al, Sn, Zn, Pb, Ni and Cr in the novolak resin solution were below the detection limits.

**Claims**

1 A method of purifying a novolak resin useful as a material for coating on a semiconductor substrate, which comprises dissolving the novolak resin in a solvent having a solubility in water at 20°C of not more than 100, and extracting the resulting solution with an acidic aqueous solution having a pH of not more than 3, thereby to reduce the metal content of the resin.

2. The method of claim 1 wherein the solvent is selected from the group consisting of acetates, ketones, alcohols, glycol ether acetates, halogenated hydrocarbons, ethers, ligroin and solvent naphtha.

3. The method of claim 1 wherein the material for coating on a semiconductor substrate is a resist or a flattening material.

4. A method of purifying a novolak resin useful as a material for coating on a semiconductor substrate, which comprises dissolving the novolak resin in a solvent having a solubility in water at 20°C of not more than 100, and thereafter subjecting the resulting solution in any desired sequence to liquid-liquid extraction with an acidic aqueous solution having a pH of not more than 3 and centrifugal separation, thereby to reduce the metal content of the resin.

5. The method of claim 4 wherein the solvent is selected from the group consisting of acetates, ketones, alcohols, glycol ether acetates, halogenated hydrocarbons, ethers, ligroin and solvent naphtha.

6. The method of claim 4 wherein the material for coating on a semiconductor substrate is a resist or a flattening material.

7. Use of the purified novolak resin obtained by the method of claim 1 as a material for coating on a semiconductor substrate.

8. Use of the purified novolak resin obtained by the method of claim 4 as a material for coating on a semiconductor substrate.